Europäisches Patentamt

European Patent Office

Office européen des brevets

(11) Veröffentlichungsnummer: **0 116 332**
A2

(12) **EUROPÄISCHE PATENTANMELDUNG**

(21) Anmeldenummer: 84100929.3

(22) Anmeldetag: 30.01.84

(51) Int. Cl.³: **H 01 L 23/52**
**H 01 L 21/90**

(30) Priorität: 10.02.83 DE 3304642

(43) Veröffentlichungstag der Anmeldung:
22.08.84 Patentblatt 84/34

(84) Benannte Vertragsstaaten:
AT DE FR GB IT SE

(71) Anmelder: SIEMENS AKTIENGESELLSCHAFT
Berlin und München Wittelsbacherplatz 2
D-8000 München 2(DE)

(72) Erfinder: Schwabe, Ulrich, Dr. phil.
Plievierpark 14
D-8000 München 83(DE)

(72) Erfinder: Neppl, Franz, Dr. rer. nat.
St.-Quirin-Platz 6
D-8000 München 90(DE)

(54) Integrierte Halbleiter mit Bipolartransistor-Strukturen und Verfahren zu ihrer Herstellung.

(57) Die Erfindung betrifft eine integrierte Halbleiterschaltung mit Bipolartransistorstrukturen, bei denen sowohl der Emitter (11)- als auch der Basisbereich (9) und der Kollektorkontaktbereich (12) durch Ausdiffusion einer mit dem entsprechenden Dotierstoff versehen, auf dem Substrat direkt abgeschiedenen Metallsilizidschicht (7, 10) erzeugt wird. Die mit der entsprechenden Dotierung versehene Metallsilizidschichtstrukturen (7, 10), wofür insbesondere Silizide der Metalle Tantal, Titan, Wolfram oder Molybdän verwendet werden, dienen als zusätzliche Verdrahtungsebenen und erlauben erlauben neben einer höheren Packungsdichte eine sehr niederohmige Kontaktierung.

FIG 3

EP 0 116 332 A2

0116332

SIEMENS AKTIENGESELLSCHAFT  Unser Zeichen
Berlin und München  VPA 83 P 1 0 6 2 E

Integrierte Halbleiterschaltung mit Bipolartransistor-
Strukturen und Verfahren zu ihrer Herstellung.

Die Erfindung betrifft eine integrierte Halbleiterschaltung mit Bipolartransistor-Strukturen, bei denen sowohl der Emitter- als auch der Basisbereich im Siliziumhalbleitersubstrat durch Ausdiffusion einer dotierten, auf dem Substrat direkt abgeschiedenen, als zusätzliche Verdrahtungsebene dienenden Schichtstruktur erzeugt sind. Die Erfindung betrifft außerdem ein Verfahren zu ihrer Herstellung.

Die kleinsten möglichen Abmessungen von Bipolar-Transistoren sind durch das relativ große Metallisierungsraster bestimmt, da aus der Metall-Leiterbahnebene Kontakte sowohl zur Emitter- und Kollektorzone als auch zur Basiszone hergestellt werden müssen.

Es gibt viele Versuche, das Verdrahtungsproblem zum Beispiel durch eine Polysiliziumverdrahtung, wie in IEEE Trans. Electron. Devices, Vol. ED-27, Nr. 8, August 1980, auf den Seiten 1379 bis 1384 in einem Aufsatz von D. D. Tang et al beschrieben, oder durch eine Polyzidverdrahtung, wie in IEEE Trans. Electron. Devices, Vol. ED-27, Nr. 8, August 1980, auf den Seiten 1385 bis 1389 in einem Aufsatz von Y. Sasaki et al, beschrieben, zu entschärfen. Polysilizium-Verdrahtungen sind jedoch relativ hochohmig und haben hohe Serienwiderstände zur Folge. Da bei diesem Vorgehen in der Regel der Emitter aus dem Polysilizium ausdiffundiert wird und die $n^+$- und $p^+$-Dotierungen ineinander diffundieren, ergibt sich außerdem eine hohe

Edt 1 Plr/25.1.1983

Emitter/Basis-Kapazität, wodurch die Grenzfrequenz beeinträchtigt wird. Die in dem Aufsatz von Sasaki veröffentlichte Anwendung von einer aus Molybdän-Silizid bestehenden Verdrahtung reduziert zwar den Verdrahtungswiderstand gegenüber der Polysiliziumverdrahtung erheblich. Das Verfahren zur Herstellung dieser Art von Verdrahtung ist aber sehr maskenaufwendig.

Es ist daher Aufgabe der Erfindung, eine integrierte Schaltung mit Bipolartransistorstrukturen anzugeben, bei der die Kontaktierung und Verbindung von Basis-, Emitter- und Kollektorgebieten unabhängig vom Metallisierungsraster ist und daher eine höhere Packungsdichte ermöglicht. Desweiteren soll der Serienwiderstand zum Basisbereich reduziert werden.

Es ist auch Aufgabe der Erfindung, ein Verfahren zur Herstellung der eingangs genannten Schaltung in möglichst einfachen, maskensparenden Verfahrensschritten anzugeben.

Die erfindungsgemäße Lösung dieser Aufgabe ist dadurch gekennzeichnet, daß die als Verdrahtungsebene dienende Schichtstruktur aus einem dotierten Silizid eines hochschmelzenden Metalles besteht. Dabei liegt es im Rahmen des Erfindungsgedankens, daß die Metallsilizidverbindung im Vergleich zur Stöchiometrie der Verbindung einen Siliziumüberschuß aufweist, um eine Reoxidation ohne Siliziumverbrauch aus dem Substrat zu ermöglichen. Vorzugsweise besteht die Verbindung aus einem Silizid der Metalle Tantal, Wolfram, Molybdän oder Titan. Die Schichtdicke der Metallsilizidstruktur liegt in einem Bereich von 150 bis 300 nm, vorzugsweise bei 200 nm.

Ausgestaltungen des Erfindungsgedankens, insbesondere ein Verfahren zur Herstellung einer integrierten Schaltung mit Bipolartransistorstrukturen, sind in Unteransprüchen gekennzeichnet.

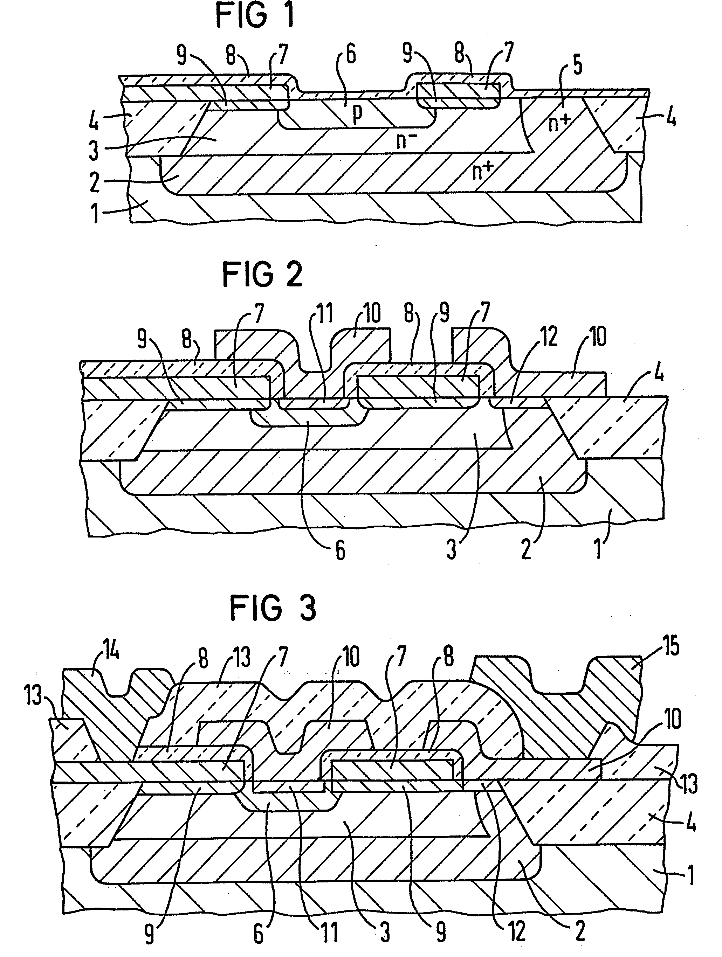

Im folgenden wird anhand der Figuren 1 bis 3 der Prozeßablauf für die Herstellung einer erfindungsgemäßen Schaltung mit einem Bipolartransistor näher beschrieben. Dabei sind in den Figuren im Schnittbild nur die erfindungswesentlichen Verfahrensschritte dargestellt; gleiche Teile sind mit gleichen Bezugszeichen versehen.

Figur 1: Auf einer einkristallinen, p-dotierten (100)-orientierten Siliziumsubstratscheibe 1 mit einem spezifischen Widerstand von 10 Ohm cm werden die aktiven Bereiche der Schaltung durch Herstellen von $n^+$-dotierten Zonen 2 durch maskierte Ionenimplantation festgelegt. Dann wird durch ein epitaktisches Abscheideverfahren auf die $n^+$-dotierten Zonen 2 eine $n^-$-dotierte Siliziumschicht 3 mit einem spezifischen Widerstand von 2 Ohm cm aufgebracht und mittels einer, die aktiven Gebiete 2 abdeckenden Maske der Isolationsgraben geätzt (in der Figur nicht dargestellt). Im Anschluß daran wird im Bereich des Isolationsgrabens das Isolationsoxid 4 erzeugt. Dann wird nach Aufbringen einer die übrigen Bereiche maskierenden Schicht die $n^+$-Tiefdiffusion 5 im Kollektorbereich des Bipolartransistors durchgeführt und nach Entfernen der Maske für die Kollektortiefdiffusion 5 die Substratoberfläche ganzflächig überätzt. Im Anschluß daran erfolgt die ganzflächige Abscheidung einer mit Bor versetzten Tantalsilizidschicht 7 (erste Silizidschicht) in einer Schichtdicke von 200 nm, wobei Silizium im Überschuß (Ta:Si < 1:2) vorliegt. Zur Festlegung des Basiskontaktbereiches (6) wird diese $TaSi_2$-Schicht 7 zur Reduzierung der Überlappungskapazitäten und zur Verhinderung der Ausdiffusion von Bor mit einer Oxidschicht 8 versehen und mit der Oxidschicht 8 so strukturiert, wie in Figur 1 dargestellt ist. Nach Erzeugung einer Implantationsmaske für die Basisimplantation (6) wird die Basis 6 mit Borionen implantiert und anschließend das Bor aus der Tantalsilizidschicht 7 bei 800 bis 1000°C ausdiffundiert. Dabei wird auch die Basisimplantation aktiviert. Es entsteht die Figur 1 mit

0116332
83 P 1062 E

der durch das Bezugszeichen 9 bezeichneten $p^+$-diffundierten Basiskontaktzone und die mit 6 bezeichnete Basis.

Figur 2: Nach Durchführung eines Oxidationsprozesses (Reoxidation des $TaSi_2$, wobei überschüssiges Silizium $SiO_2$ bildet) wird in der Emitterzone (11) und im Kollektorkontaktbereich (12) die Oxidschicht durch ein anisotropes Trockenätzverfahren entfernt, wobei an den Silizidflanken $SiO_2$ stehenbleibt. Auf den offengelegten Emitter- und Kollektorkontaktanschlußbereichen wird mit Arsen dotiertes Tantalsilizid 10 (zweite Silizidschicht) durch Zerstäuben eines mit Arsen dotierten Tantalsilizid-Targets abgeschieden und wie aus Figur 2 ersichtlich, strukturiert. Dabei wird die erste Silizidschicht 7 von der zweiten Silizidschicht 10 überlappt. Zur Emitterbildung (Zone 11) wird dann Arsen aus der Tantalsilizidschicht 10 bei 800-1000°C ausdiffundiert. Gleichzeitig entsteht der diffundierte $n^+$-Kollektorkontaktanschluß 12.

Figur 3 zeigt die fertige Bipolartransistorstruktur nach Erzeugung einer als Zwischenoxid wirkenden Isolationsschicht 13, Öffnen der Kontakte zu den Bor-dotierten Bereichen der ersten Tantalsilizidschicht 7 ($p^+$-Basis 9) und zu den Arsen-dotierten Bereichen der zweiten Tantalsilizidschicht 10 ($n^+$-Kollektorzone 12 bzw. Emitter 11) und nach erfolgter Metallisierung mit Aluminium-Kontakten 14 und 15.

Der Vorteil der Erfindung gegenüber bekannten Bipolartransistorstrukturen sowie deren Herstellung liegt darin, daß mit nur einer zusätzlichen Maske (Kontakt zwischen dem ersten und zweiten Metallsilizid) zusätzlich zwei niederohmige, nahezu unabhängige Verdrahtungsebenen (7 und 10), die insbesondere als Kreuzkopplung in statischen Speicherzellen eine höhere Packungsdichte ermöglichen, gewonnen werden.

Durch die erfindungsgemäße Anordnung ergeben sich außerdem folgende Vorteile:

1. der Kontakt Metall/Silizid (14 + 7, 15 + 10) ist eine Größenordnung niederohmiger als der bekannte Kontakt Metall/Polysilizium.

2. Die Zuleitung vom Kontakt: Metall/Silizid (14, 7) zur Basis (9) ist eine Größenordnung niederohmiger als bei Verwendung von Polysilizium.

3. Bei der kritischen Ätzung von Silizid (7, 10) auf Silizium ist wegen der unterschiedlichen Materialien leichter ein Ätzstop zu erzielen bzw. eine Endpunktkontrolle durchzuführen als bei Verwendung von Polysilizium.

10 Patentansprüche
3 Figuren

Patentansprüche

1. Integrierte Halbleiterschaltung mit Bipolartransistor-strukturen, bei denen sowohl der Emitter- als auch der Basisbereich im Siliziumhalbleitersubstrat durch Ausdiffusion einer dotierten, auf dem Substrat direkt abgeschiedenen, als zusätzliche Verdrahtungsebene dienen-den Schichtstruktur erzeugt sind, d a d u r c h   g e -k e n n z e i c h n e t ,   daß die als Verdrahtungsebene dienende Schichtstruktur (7, 10) aus einem dotierten Silizid eines hochschmelzenden Metalles besteht.

2. Integrierte Halbleiterschaltung mit Bipolartransis-torstrukturen nach Anspruch 1, d a d u r c h   g e -k e n n z e i c h n e t ,   daß die Metallsilizidverbin-dung (7, 10) im Vergleich zur Stöchiometrie einen Sili-ziumüberschuß aufweist.

3. Integrierte Halbleiterschaltung mit Bipolartransistorstrukturen nach Anspruch 1 und/oder Anspruch 2,   d a -d u r c h   g e k e n n z e i c h n e t ,   daß die Metallsilizidverbindung (7, 10) aus den Siliziden der Metalle Tantal, Titan, Wolfram oder Molybdän besteht.

4. Integrierte Halbleiterschaltung mit Bipolartransistor-strukturen nach Anspruch 1 bis 3, d a d u r c h   g e -k e n n z e i c h n e t ,   daß die Schichtdicke der Metallsilizidstrukturen (7, 10) 150 bis 300 nm, vorzugsweise 200 nm beträgt.

5. Verfahren zum Herstellen von npn-Bipolartransistor-strukturen, bei denen sowohl der Emitter- als auch der Basisbereich im Halbleitersubstrat durch Ausdiffusion einer dotierten, auf dem Substrat direkt abgeschiedenen, als zusätzliche Verdrahtungsebene dienenden Schichtstruktur erzeugt werden nach einem der Ansprüche 1 bis 4, g e k e n n z e i c h n e t   d u r c h   den Ablauf der

folgenden Verfahrensschritte:

a) Festlegung der aktiven Bereiche der Schaltung durch Herstellen von $n^+$-dotierten Zonen (2) in einem p-dotierten Siliziumsubstrat (1) durch maskierte Ionenimplantation,

b) Aufbringen einer epitaxialen n-dotierten Schicht (3) auf die $n^+$-dotierten Zonen (2),

c) maskiertes Ätzen des Isolationsgrabens im Bereich zwischen den $n^+$-dotierten Zonen (2),

d) Erzeugen des Isolationsoxids (4) im Bereich des Isolationsgrabens,

e) $n^+$-Tiefdiffusion (5) im Kollektorbereich nach Aufbringen einer, die übrigen Bereiche maskierenden Schicht,

f) Ablösen der maskierenden Schicht für die Kollektor-Tiefdiffusion und Überätzen der Substratoberfläche,

g) ganzflächige Abscheidung einer mit p-dotierenden Stoffen versetzten, ersten Metallsilizidschicht (7), wobei Silizium im Überschuß vorliegt,

h) Strukturierung der p-dotierten Silizidschicht (7) im Basisbereich des Transistors,

i) Durchführung der Basisimplantation (6) mit p-dotierenden Ionen nach Erzeugung der Maske für die Basisimplantation,

j) Ausdiffusion der p-dotierenden Stoffe aus dem Silizid (7) Basiskontaktbereich (9), k) Durchführung eines Oxidationsprozesses,

l) Durchführung eines anisotropen Trockenätzverfahrens zur Entfernung der Oxidschicht in der Emitter (11)- und Kollektoranschlußzone (12),

m) ganzflächige Abscheidung einer mit n-dotierenden Stoffen versehen, zweiten Metallsilizidschicht (10),

n) Strukturierung der zweiten n-dotierten Silizidschicht (10) im Emitterbereich (11) und Kollektorkontaktbereich (12), wobei die Strukturen die Strukturen der ersten Metallsilizidschicht (7) überlappen,

o) Ausdiffusion der n-dotierenden Stoffe aus der zweiten Silizidschicht (10), wobei die Emitterzone (11) gebildet wird,

p) ganzflächige Abscheidung einer als Zwischenoxid wirkenden Isolationsschicht (13),

q) Öffnen der Kontakte zu den p-dotierten Bereichen der ersten Metallsilizidschicht (7) und zu den n-dotierten Bereichen (12) der zweiten Metallsilizidschicht (10),

r) Durchführung der Metallisierung und Strukturierung der äußeren Metall-Leiterbahnebene (14).

6. Verfahren nach Anspruch 5, d a d u r c h  g e - k e n n z e i c h n e t , daß zwischen Verfahrensschritt g) und h) eine Oxidschicht (8) abgeschieden wird, die mit der ersten Silizidschicht (7) strukturiert wird, wobei ein leichter SiO$_2$-Überhang entsteht.

7. Verfahren nach Anspruch 5, d a d u r c h  g e - k e n n z e i c h n e t , daß zwischen Verfahrens-

schritt g) und h) eine Oxidschicht (8) abgeschieden wird, die mit der ersten Silizidschicht (7) strukturiert wird und daß anstelle von Verfahrensschritt k) eine Oxidschicht aus der Dampfphase abgeschieden wird.

8. Verfahren nach Anspruch 5 bis 7, d a d u r c h g e k e n n z e i c h n e t , daß als Silizid (7, 10) bei Verfahressnchritt g) und bei Verfahrensschritt m) ein Silizid eines der Metalle Tantal, Titan, Wolfram oder Molybdän verwendet wird.

9. Verfahren nach einem der Ansprüche 5 bis 8, d a - d u r c h g e k e n n z e i c h n e t , daß für die Dotierung der ersten Metallsilizidschicht (7) (Verfahrensschritt g) Bor und für die Dotierung der zweiten Metallsilizidschicht (10) (Verfahrensschritt m) Arsen verwendet wird.

10. Verfahren nach einem der Ansprüche 5 bis 9, d a - d u r c h g e k e n n z e i c h n e t , daß als Metallisierung für die äußere Metall-Leiterbahnebene (14) gemäß Verfahrensschritt r) Aluminium verwendet wird.

FIG 1

FIG 2

FIG 3